# FASCICULE DE BREVET EUROPEEN

(11) **EP 4 490 774 B1**
(45) Date de publication et mention de la délivrance du brevet: **02.12.2026**
(21) Numéro de dépôt: 23713725.2
(22) Date de dépôt: 10.03.2023
(51) Int. Cl.: H10P 36/20, H10P 90/00, H10W 10/10

(54) **PROCÉDÉ DE FABRICATION D'UNE STRUCTURE MULTICOUCHE DE TYPE SEMI-CONDUCTEUR SUR ISOLANT**
VERFAHREN ZUR HERSTELLUNG EINER MEHRSCHICHTIGEN HALBLEITER-AUF-ISOLATOR-STRUKTUR
METHOD FOR PRODUCING A SEMICONDUCTOR-ON-INSULATOR MULTILAYER STRUCTURE

(30) Priorité: 11.03.2022 FR 2202151
(43) Date de publication de la demande: 15.01.2025
(73) Titulaire: SOITEC, 38190 Bernin (FR)
(72) Inventeur: BERTRAND, Isabelle, 38190 BERNIN (FR); BOUVEYRON, Romain, 38190 BERNIN (FR); GHORBEL, Aymen, 38190 BERNIN (FR)
(74) Mandataire: Regimbeau
(86) Numéro de dépôt international: PCT/FR2023/050325
(87) Numéro de publication internationale: WO 2023/170370

(56) Documents cités:
- EP-A1- 0 165 364
- EP-A1- 3 144 958
- FR-A1- 3 106 019
- SU XIN ET AL: "Investigation on Evolution of Oxygen Precipitates in Bonded SOI Substrate", ECS JOURNAL OF SOLID STATE SCIENCE AND TECHNOLOGY, vol. 8, no. 3, 1 January 2019 (2019-01-01), US, pages P186 - P189, XP055969368, ISSN: 2162-8769, DOI: 10.1149/2.0081903jss
- BORGHESI A ET AL: "OXYGEN PRECIPITATION IN SILICON", JOURNAL OF APPLIED PHYSICS, AMERICAN INSTITUTE OF PHYSICS, 2 HUNTINGTON QUADRANGLE, MELVILLE, NY 11747, vol. 77, no. 9, 1 May 1995 (1995-05-01), pages 4169 - 4244, XP000504591, ISSN: 0021-8979, DOI: 10.1063/1.359479

## Description

### DOMAINE DE L'INVENTION

L'invention concerne un procédé de fabrication d'une structure multicouche de type semi-conducteur sur isolant.

### ETAT DE LA TECHNIQUE

Les structures de type semi-conducteur sur isolant sont des structures multicouches comprenant un substrat support qui est généralement en un matériau semi-conducteur tel que du silicium, une couche électriquement isolante agencée sur le substrat support, qui est généralement une couche d'oxyde telle qu'une couche d'oxyde de silicium, et une couche semi-conductrice agencée sur la couche isolante, qui est généralement une couche de silicium. De telles structures sont dites structures « Semiconductor on Insulator » en anglais, en particulier « Silicon on Insulator » (SOI) lorsque le matériau semi-conducteur est du silicium. La couche d'oxyde se trouve entre le substrat et la couche semi-conductrice. La couche d'oxyde est alors dite « enterrée », et est appelée « BOX » pour « Buried Oxide » en anglais. Dans la suite du texte, on emploiera le terme « SOI » pour désigner d'une manière générale les structures de type semi-conducteur sur isolant.

De telle structures SOI peuvent être obtenues par un procédé impliquant le transfert d'une couche semi-conductrice monocristalline issue d'un substrat donneur, sur la face avant du substrat support, une couche électriquement isolante étant à l'interface entre la couche semi-conductrice transférée et le substrat support.

Pour des applications dans le domaine des hautes fréquences, un enjeu réside dans la fabrication de structures SOI spécifiques dont les performances ne pâtissent pas de pertes électriques engendrées par des flux d'électrons depuis un canal de conduction formé dans ou sur la couche semi-conductrice vers le substrat support. A cet effet, le procédé peut par exemple comprendre l'utilisation d'un substrat support présentant une haute résistivité électrique et éventuellement la combinaison dudit substrat support avec une couche de piégeage de charges (« trap-rich layer » en anglais).

Un autre enjeu réside dans la fabrication de structures SOI capables d'endurer des traitements thermiques sévères sans développer de lignes de glissement (« slip lines » en anglais). Les lignes de glissement consistent en des plans de fracture où la structure cristalline s'est décalée. Sans obstacles, des dislocations peuvent se propager jusqu'à la surface des plaques où elles créent des marches de plans atomiques ou lignes de glissement. Lors d'étapes ultérieures de lithographie, de telles marches engendrent notamment des problèmes de désalignement des motifs de lithographie (problème connu par l'homme du métier sous la dénomination anglaise d'« overlay »). Afin de limiter l'apparition de ces lignes de glissement, le procédé peut utiliser, en guise de substrat support, un substrat dans lequel on a préalablement intégré de l'oxygène en position interstitielle à plus ou moins forte concentration. L'oxygène interstitiel bloque la propagation des dislocations et empêche de ce fait l'apparition de marches en surface de plaques.

L'oxygène interstitiel présente cependant l'inconvénient de générer des donneurs thermiques qui peuvent faire varier la résistivité électrique du substrat support. L'oxygène interstitiel tend à faire baisser la valeur de la résistivité électrique. Or, pour des applications dans le domaine des radiofréquences notamment, la résistivité électrique doit être contrôlée et maintenue stable, à une valeur élevée.

Afin de pallier cet inconvénient, une solution consiste à utiliser un substrat faiblement enrichi en oxygène interstitiel en guise de substrat support. La concentration en oxygène interstitiel de tels substrats (communément appelés « low Oi » selon la terminologie anglo-saxonne) est typiquement comprise entre 6 et 10 old ppma, l'unité old ppma désignant une « partie par million d'atomes » selon une ancienne spécification de mesure normalisée ASTM79. Une telle concentration d'oxygène interstitiel est un compromis relativement satisfaisant pour des composants électroniques de taille importante fabriqués à partir de ces substrats permettant de limiter le nombre de lignes de glissement tout en contrôlant la résistivité dudit substrat.

Toutefois, la tendance étant à la miniaturisation, le développement de lignes de glissement, même en très faible quantité, dans des composants électroniques de petites dimensions est de moins en moins toléré. L'utilisation de substrats faiblement enrichis peut conduire à un taux d'oxygène interstitiel trop faible pour atteindre les performances attendues. La solution consistant simplement à augmenter le taux d'oxygène interstitiel du substrat n'est pas satisfaisante, car une concentration trop importante d'Oi ne permet plus de contrôler la valeur de la résistivité électrique.

En revanche, une solution envisageable consiste à augmenter la concentration en oxygène interstitiel initiale du substrat support et, par l'application de traitements thermiques, à faire précipiter ledit oxygène interstitiel sous la forme de précipités d'oxygène ou défauts connus sous l'acronyme BMD, du terme anglo-saxon « Bulk Micro Defects »).

La concentration en oxygène interstitiel initiale du substrat est typiquement supérieure à 27 old ppma. L'utilisation de substrats fortement enrichis en oxygène interstitiel (communément appelés « high Oi » selon la terminologie anglo-saxonne) permet d'obtenir une densité de l'ordre de 10¹⁰ précipités d'oxygène ou défauts par cm³, la dimension desdits précipités étant comprise entre 70 et 120 nm. Les précipités d'oxygène sont alors suffisamment gros et nombreux pour, de la même façon que l'oxygène interstitiel, bloquer la propagation des dislocations.

Toutefois, une telle configuration ne permet pas le contrôle et le maintien de la résistivité du substrat support à une valeur stable et suffisamment élevée pour des applications dans le domaine radiofréquence. En outre, si les précipités d'oxygène sont trop nombreux et trop gros, ils engendrent localement des contraintes mécaniques au cœur du matériau qui peuvent causer une déformation globale du substrat. La déformation du substrat peut également être à l'origine de problèmes d'alignement des motifs de lithographie. Les documents suivants constituent l'état de la technique.

Le document FR3110283A1 décrit un procédé de fabrication d'un substrat semi-conducteur sur isolant pour applications radiofréquences. Le procédé inclut la formation d'un substrat donneur par croissance épitaxiale, l'implantation d'espèces ioniques, et le transfert d'une couche mince semi-conductrice sur un substrat support à haute résistivité, tout en évitant la diffusion des dopants.

Le document de SU XIN ET AL: "Investigation on Evolution of Oxygen Precipitates in Bonded SOI Substrate", ECS JOURNAL OF SOLID STATE SCIENCE AND TECHNOLOGY, vol. 8, no. 3, 1 janvier 2019 (2019-01-01), XP055969368 -étudie l'évolution des précipités d'oxygène dans les substrats SOI liés et leur impact sur l'expansion des tranches. Il propose un traitement thermique supplémentaire pour contrôler la densité et la taille des précipités d'oxygène, améliorant ainsi la résistance des tranches et réduisant leur expansion pendant la lithographie.

Le document de BORGHESI A ET AL: "OXYGEN PRECIPITATION IN SILICON",JOURNAL OF APPLIED PHYSICS, AMERICAN INSTITUTE OF PHYSICS, 2 HUNTINGTON QUADRANGLE, MELVILLE, NY 11747, vol. 77, no. 9, 1 mai 1995 (1995-05-01), pages 4169-4244, XP000504591 - présente une revue des avancées récentes dans l'étude de la précipitation de l'oxygène et des propriétés des précipités d'oxyde dans le silicium. Il couvre la thermodynamique et la cinétique de la formation des précipités, les techniques de caractérisation, et l'impact sur les applications technologiques, notamment le rendement des dispositifs.

Le document EP3144958A1 décrit une structure pour applications radiofréquences avec un substrat monocristallin et une couche de silicium polycristallin contenant du carbone et/ou de l'azote aux joints de grains. Le procédé de fabrication inclut le dépôt de la couche polycristalline et le transfert de la couche active.

Le document EP0165364A1 décrit un procédé de standardisation et de stabilisation des tranches semiconductrices pour les rendre aptes à être traitées sur des lignes de fabrication de dispositifs bipolaires et unipolaires. Le procédé inclut le tri des tranches par taux de précipitation et un cycle thermique d'adaptation pour créer une zone sans défaut.

### EXPOSE DE L'INVENTION

Un but de l'invention est de concevoir une structure de type semi-conducteur sur isolant telle que le substrat support présente une bonne résistance au développement ultérieur de lignes de glissement tout en présentant une résistivité électrique élevée et contrôlée, et sans pour autant engendrer de contraintes mécaniques importantes au sein dudit substrat support qui pourraient causer sa déformation globale.

Par « haute résistivité électrique », on entend dans le présent texte une résistivité électrique supérieure ou égale à 500 Ω.cm.

Un autre but de l'invention est de concevoir une structure de type semi-conducteur sur isolant qui n'engendre pas, lors d'étapes de fonctionnalisation ultérieures, les problèmes d'« overlay » connus de l'homme du métier, même pour la fabrication de composants appliqués au domaine des hautes fréquences dont les longueurs de grilles sont inférieures à 65 nm, par exemple inférieures à ou de l'ordre de 22 nm.

A cet effet, l'invention propose un procédé de fabrication d'une structure multicouche de type semi-conducteur sur isolant comprenant les étapes suivantes :
- assemblage d'un substrat support présentant une résistivité électrique supérieure ou égale à 500 Ω.cm et contenant de l'azote interstitiel et de l'oxygène interstitiel, la concentration initiale en oxygène interstitiel dans le substrat support étant comprise entre 15 old ppma et 25 old ppma (mesurée selon la norme ASTM79), et d'un substrat donneur d'une couche semi-conductrice à transférer, une couche électriquement isolante étant à l'interface entre le substrat support et le substrat donneur,
- transfert de ladite couche semi-conductrice sur le substrat support,
le procédé comprenant en outre une étape de nucléation comprenant un traitement thermique pour précipiter de façon contrôlée au moins une partie de l'oxygène interstitiel et au moins une partie de l'azote interstitiel de sorte à former des germes de précipités d'oxygène et d'azote et une étape de stabilisation comprenant un traitement thermique pour faire croître lesdits germes de précipités d'oxygène et d'azote jusqu'à une taille comprise entre 10 nm et 50 nm..

L'ajout d'azote interstitiel apporte une résistance à la propagation des dislocations sans pour autant dégrader la résistivité du substrat support. En outre, de par son affinité avec l'oxygène, il aide à la précipitation de l'oxygène interstitiel.

L'ajout d'oxygène interstitiel, dans une concentration contrôlée intermédiaire entre les concentrations des substrats « low Oi » et « high Oi », conjointement à l'ajout d'azote interstitiel permet d'améliorer encore la résistance au développement ultérieur de lignes de glissement, y compris pour des substrats de très faibles épaisseurs pour lesquels les problèmes d'« overlay » deviennent critiques.

Le contrôle de la taille et de la concentration des précipités d'oxygène et d'azote lors des étapes de nucléation et de croissance permet également de contrôler la résistance au développement ultérieur de lignes de glissement en limitant la propagation de dislocations au sein du substrat support. En outre, en fixant plus ou moins l'azote interstitiel et l'oxygène interstitiel, lesdites étapes permettent de contrôler la résistivité du substrat support, y compris la résistivité de substrats support fortement résistifs pour des applications dans le domaine des hautes fréquences.

Selon d'autres caractéristiques de l'invention prises seules ou en combinaison lorsque cela est techniquement possible :
- le procédé comprend, en outre, avant l'étape d'assemblage, la formation d'une couche de piégeage de charges sur le substrat support, ladite couche de piégeage de charges étant agencée entre le substrat support et la couche électriquement isolante,
- la formation de ladite couche de piégeage de charges comprend le dépôt d'une couche de silicium polycristallin sur le substrat support,
- le dépôt de ladite couche de silicium polycristallin est réalisé après l'étape de stabilisation des précipités d'oxygène et d'azote,
- la concentration initiale en azote interstitiel dans le substrat support est comprise entre 10¹⁴ atomes/cm³ et 10¹⁵ atomes/cm³,
- à l'issue de l'étape de stabilisation, le substrat support comprend une concentration en précipités d'oxygène et d'azote comprise entre 10⁷ cm⁻³ et 10¹⁰ cm⁻³, préférentiellement une concentration comprise entre 10⁸ cm⁻³ et 10⁹ cm⁻³,
- l'étape de nucléation et l'étape de stabilisation comprennent chacune un traitement thermique, la température appliquée durant le traitement thermique de nucléation étant inférieure à la température appliquée lors du traitement thermique de stabilisation et la durée du traitement thermique de nucléation étant inférieure à la durée du traitement thermique de stabilisation,
- l'étape de nucléation comprend l'application d'une température comprise entre 650 °C et 800 °C, préférentiellement une température comprise entre 700 °C et 750 °C, pendant une durée supérieure à une heure, préférentiellement une durée de deux heures,
- l'étape de stabilisation comprend l'application d'une température supérieure à 900 °C, préférentiellement une température de 950 °C, pendant une durée supérieure à deux heures, préférentiellement une durée de quatre heures,
- les étapes de nucléation et de stabilisation sont exécutées directement l'une à la suite de l'autre avant l'étape d'assemblage.

L'invention concerne également un substrat pour la microélectronique, l'optoélectronique et/ou l'optique comportant, de sa face arrière vers sa face avant, un substrat support, une couche électriquement isolante et une couche semi-conductrice, caractérisé en ce que le substrat support est réalisée en un matériau semi-conducteur présentant une résistivité électrique supérieure ou égale à 500 Ω.cm et comportant des précipités d'oxygène et d'azote présentant une taille comprise entre 10 nm et 50 nm, dans une concentration comprise entre 10⁷ cm⁻³ et 10¹⁰ cm⁻³.

Selon d'autres caractéristiques de l'invention prises seules ou en combinaison lorsque cela est techniquement possible :
- le substrat comprend en outre une couche de piégeage de charge entre le substrat support et la couche électriquement isolante,
- la concentration résiduelle en oxygène interstitiel dans le substrat support est inférieure à 15 old ppma, préférentiellement inférieure à 12 old ppma (mesurée selon la norme ASTM79).

### BREVE DESCRIPTION DES FIGURES

D'autres caractéristiques et avantages de l'invention ressortiront de la description détaillée qui va suivre, en référence aux dessins annexés, sur lesquels :

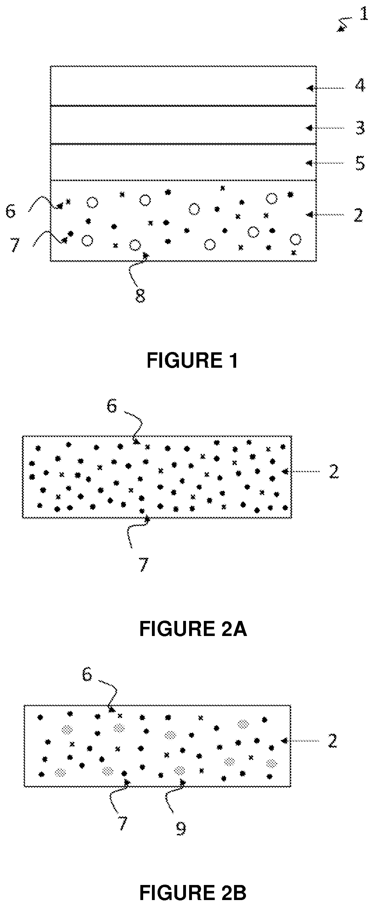

- la figure 1 représente une structure multicouche de type semi-conducteur sur isolant selon l'invention, le substrat support comportant des précipités d'oxygène et d'azote (ronds blancs), de l'azote interstitiel résiduel (croix noires) et de l'oxygène interstitiel résiduel (points noirs),

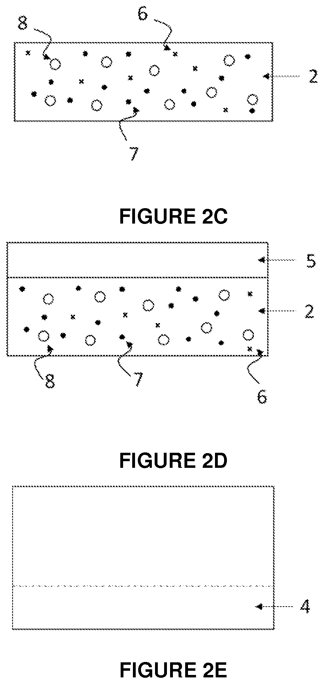

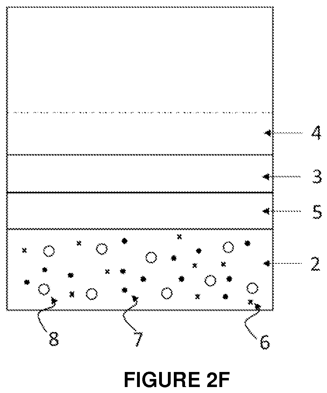

- les figures 2A à 2F représentent un mode de réalisation du procédé selon l'invention dans lequel, à partir d'un substrat support comprenant de l'azote interstitiel et de l'oxygène interstitiel (figure 2A), on réalise successivement une étape de nucléation pour la formation de germes de précipités d'oxygène et d'azote (ronds gris) (figure 2B), une étape de croissance des germes en précipités d'oxygène et d'azote stables (ronds blancs) (figure 2C), une éventuelle étape de formation d'une couche de piégeage de charges sur le substrat support (figure 2D), une étape d'agencement d'un substrat donneur d'une couche semi-conductrice à transférer (figure 2E) sur le substrat support (figure 2F) et une étape de transfert de la couche semi-conductrice de sorte à obtenir la structure multicouche de type semi-conducteur sur isolant représentée sur la figure1.

Pour des raisons de lisibilité, les dessins ne sont pas nécessairement réalisés à l'échelle.

### DESCRIPTION DETAILLEE DE MODES DE REALISATION

Un premier objet de l'invention concerne une structure multicouche de type semi-conducteur sur isolant qui présente une résistance particulière à la propagation de dislocations et minimise ainsi la formation de lignes de glissement lors de traitements thermiques de « back-end ». En outre, la résistivité électrique du substrat support de ladite structure multicouche est stable lors desdits traitements thermiques. A titre d'exemple, la structure multicouche conforme à l'invention peut présenter des longueurs de grilles inférieures à 65 nm, par exemple de l'ordre de 22 nm, tout en ne développant pas ou peu de lignes de glissement lorsqu'on lui applique une température de l'ordre de 450 °C pendant une heure. En outre, le substrat support de la structure multicouche peut présenter une résistivité électrique cible comprise entre 500 Ohm.cm et 5000 Ohm.cm tout en demeurant stable. La structure multicouche de type semi-conducteur sur isolant objet de l'invention trouve une application par exemple dans le domaine des radiofréquences pour lequel des substrats supports hautement résistifs trouvent un intérêt particulier.

La Figure 1 illustre un mode de réalisation d'une telle structure multicouche 1 selon l'invention. La structure multicouche 1 comprend successivement, depuis une face arrière vers une face avant de la structure, un substrat support 2, une couche électriquement isolante 3 et une couche semi-conductrice 4.

Le substrat support 2 de la structure multicouche 1 est en un matériau semi-conducteur hautement résistif. La résistivité électrique du substrat support est supérieure ou égale à 500 ohm.cm. Une résistivité électrique élevée confère au substrat support la capacité de limiter les pertes électriques et d'améliorer les performances radiofréquences de la structure.

Le substrat support 2 de la structure multicouche 1 comporte des précipités d'oxygène et d'azote 8, également connus sous l'acronyme BMD, du terme anglo-saxon « Bulk Micro Defects ». Les BMD présentent la propriété de bloquer la propagation de dislocations qui tendent à se développer lorsque la structure multicouche 1 est soumise à des traitements thermiques. Les BMD permettent ainsi d'éviter que les dislocations ne remontent jusqu'à la surface de la structure multicouche 1, y créant des décalages de plans atomiques. De tels décalages sont notamment à l'origine de problèmes d'alignement connus par l'homme du métier sous l'appellation d'« overlay ».

La taille des précipités d'oxygène et d'azote 8 au sein du substrat support 2 de la structure multicouche 1 est comprise entre 10 nm et 50 nm, préférentiellement comprise entre 40 nm et 50 nm. La gamme de tailles ainsi choisie constitue un compromis avantageux permettant de limiter fortement le nombre de lignes de glissement générées en surface sans pour autant engendrer des contraintes mécaniques trop importantes dans le matériau. En effet, des précipités d'oxygène et d'azote trop petits ne bloqueraient pas efficacement le développement des dislocations. Des précipités trop gros risqueraient en revanche de générer des contraintes mécaniques importantes au sein du matériau de sorte que le matériau se trouverait déformé. Par ce compromis, on minimise par conséquent le phénomène d'overlay précédemment mentionné.

La concentration des précipités d'oxygène et d'azote 8 au sein du substrat support 2 est comprise entre 10⁷ et 10¹⁰ précipités par cm³, préférentiellement comprise entre 10⁸ et 10⁹ précipités par cm³. Si la concentration en précipités est inférieure à 10⁷ précipités par cm³, les précipités d'oxygène et d'azote ne sont pas suffisamment nombreux pour bloquer efficacement la propagation des dislocations. Si la concentration en précipités est supérieure à 10¹⁰ précipités par cm³, le risque de générer des contraintes mécaniques au sein du matériau devient important.

La taille et la densité des précipités d'oxygène et d'azote 8 est mesurée par tomographie de diffusion laser connu sous l'acronyme LST, du terme anglo-saxon « Laser scattering tomography ».

Le substrat support 2 peut comprendre également de l'azote interstitiel 6 et de l'oxygène interstitiel 7 résiduels, c'est-à-dire ne contribuant pas aux précipités 8. Tout comme les BMD, l'oxygène interstitiel 7 et l'azote interstitiel 6 s'opposent à la propagation des dislocations. Toutefois, l'oxygène interstitiel 7 peut contribuer à la génération de donneurs thermiques qui risquent d'induire une chute non contrôlée de la résistivité électrique. Ces donneurs thermiques sont générés lorsque la structure multicouche 1 subit des traitements thermiques de « back-end », par exemple lorsqu'on applique à la structure une température comprise entre 375 °C et 450 °C pendant quelques minutes à une ou deux heures. Ce genre de traitement thermique est typiquement appliqué à la structure multicouche lors du recuit final visant à guérir les défauts générés lors des dernières étapes de fabrication de la puce connues de l'homme du métier sous l'appellation anglo-saxonne « back end of line ». Lors de ce recuit dit de passivation, l'hydrogène présent dans l'atmosphère du four diffuse jusqu'aux interfaces pour guérir des liaisons pendantes.

Afin de limiter le phénomène de génération de donneurs thermiques, la concentration en oxygène interstitiel 7 résiduel du substrat support 2 est inférieure à 15 ppma, préférentiellement inférieure à 12 ppma. En effet, plus la concentration d'oxygène interstitiel 7 au sein du substrat support 2 est basse, meilleur est le contrôle de la résistivité électrique dudit substrat 2 dans les diverses applications de la structure multicouche 1.

Comme précédemment mentionné, le terme old ppma désigne une « partie par million d'atomes » selon une ancienne spécification de mesure normalisée ASTM79.

La concentration en oxygène interstitiel 7 est déterminée grâce à un modèle de génération de donneurs thermiques : on applique au substrat le traitement thermique de 450 °C pendant une heure (connu de l'homme du métier sous l'acronyme DGA selon l'appellation anglo-saxonne « Donor Generation Anneal ») et on mesure la résistivité électrique dudit substrat avant et après le traitement thermique de DGA. Un modèle permet de relier la variation entre les deux mesures de la résistivité électrique, qui est liée à la génération de donneurs thermiques, à la concentration en oxygène interstitiel résiduel. La résistivité électrique est mesurée par SRP ou « Spreading Resistance Profile ».

Optionnellement, la structure 1 comprend également une couche de piégeage de charges 5, préférentiellement en silicium polycristallin ou en silicium poreux, agencée entre le substrat support 2 et la couche électriquement isolante 3. Cette couche de piégeage de charges permet de piéger les charges électriques qui s'accumulent sous la première couche électriquement isolante 3. La couche de piégeage de charges 5 est particulièrement avantageuse pour des applications radiofréquences de la structure multicouche 1.

La couche électriquement isolante 3 peut être une couche d'oxyde, par exemple une couche d'oxyde de silicium. D'autres matériaux comme le nitrure de silicium ou encore l'oxynitrure de silicium peuvent être envisagés. La couche semi-conductrice 4 est une couche en un matériau semi-conducteur, par exemple une couche de silicium monocristallin. De manière non-limitative, la couche semi-conductrice 4 peut être remplacée par une couche active de tout autre matériau, en particulier par une couche piézoélectrique comme par exemple du tantalate de lithium ou du niobate de lithium. D'autres matériaux comme le nitrure de gallium, l'arséniure de gallium ou encore le phosphure d'indium peuvent être utilisés.

### Procédé de fabrication

Un deuxième objet de l'invention concerne un procédé de fabrication d'une structure multicouche telle que décrite précédemment par précipitation d'oxygène interstitiel et d'azote interstitiel de sorte à former des précipités d'oxygène et d'azote au sein du substrat support de la structure multicouche.

En référence à la Figure 2A, on fournit initialement un substrat 2. Le substrat 2 est en un matériau semi-conducteur hautement résistif qui comprend initialement de l'azote interstitiel 6 et de l'oxygène interstitiel 7. Le substrat 2 est par exemple une plaque circulaire de silicium de 300 mm de diamètre. Le substrat 2 peut être préparé par tirage d'un lingot du matériau semi-conducteur dans une atmosphère de dioxygène et d'azote. La teneur en oxygène et en azote interstitiel est généralement contrôlée par le fabricant du lingot et indiquée dans les spécifications techniques des substrats.

L'ajout d'azote interstitiel 6 en plus de l'oxygène interstitiel 7 permet d'obtenir un substrat plus résistant à la propagation des dislocations. L'azote interstitiel 6, par son affinité avec l'oxygène, aide à la précipitation des précipités d'oxygène et d'azote. Pour une même concentration initiale en oxygène interstitiel 7 du substrat 2, l'ajout d'azote interstitiel 6 permet de générer une densité plus grande de précipités. En outre, les précipités générés en présence d'azote interstitiel 6 sont plus petits. Le taux d'azote interstitiel 6 du substrat 2 est préférentiellement compris entre 10¹⁴ atomes/cm³ et 10¹⁵ atomes/cm³.

La concentration en oxygène interstitiel 7 du substrat 2 est choisie supérieure à celle des substrats qualifiés de « low Oi », de sorte à permettre la précipitation dudit oxygène. Néanmoins, la concentration en oxygène interstitiel 7 du substrat 2 est choisie inférieure à celle des substrats qualifiés de « high Oi » afin de générer, lors de la précipitation, une densité plus faible de précipités qu'à partir d'un substrat « high Oi ». En outre, les dimensions desdits précipités sont moins importantes que celles des précipités générés au sein d'un substrat « high Oi ». Enfin, à l'issue de la précipitation, la concentration en oxygène interstitiel résiduel est plus faible que dans les substrats « high Oi ».

De cette façon, on obtient un substrat présentant une meilleure résistance à la propagation des dislocations qu'un substrat « low Oi ». La densité et la dimension des précipités génèrent moins de contraintes mécaniques que celles obtenues à partir d'un substrat « high Oi ». La faible concentration en oxygène interstitiel résiduel permet de limiter la génération de donneurs thermiques et ainsi de mieux contrôler la résistivité du substrat.

En d'autres termes, la concentration en oxygène interstitiel 7 du substrat 2 est intermédiaire entre la concentration en oxygène interstitiel des substrats « low Oi » et la concentration en oxygène interstitiel des substrats « high Oi ». La concentration en oxygène interstitiel 7 du substrat 2 est préférentiellement comprise entre 15 old ppma et 25 old ppma.

Dans la suite, on décrit un mode préféré de réalisation du procédé. En référence au figures 2B à 2F, ce procédé comprend au moins les étapes successives suivantes :
- une étape de nucléation de sorte à créer des germes de précipités d'oxygène et d'azote 9 au sein du substrat support 2 (c),
- une étape de stabilisation de sorte à faire croitre les germes de précipités d'oxygène et d'azote 8 au sein dudit substrat support 2 (d),
- une étape optionnelle de formation d'une couche de piégeage de charges 5 sur le substrat support 2 (e),
- une étape d'agencement d'un substrat donneur d'une couche semi-conductrice à transférer 4 sur le substrat support 2, une couche électriquement isolante 3 étant à l'interface entre le substrat support 2 et la couche à transférer 4 (a),
- une étape de transfert de la couche semi-conductrice 4 (b).

### Etape de nucléation (c) et étape de stabilisation (d)

Lors de l'étape de nucléation (c), l'azote interstitiel 6 et l'oxygène interstitiel 7 diffusent au sein du matériau du substrat 2. En outre, les liaisons entre certains des atomes dudit matériau semi-conducteur se rompent tandis que de nouvelles liaisons se forment entre les atomes du matériau semi-conducteur et l'azote, entre les atomes du matériau semi-conducteur et l'oxygène, et entre l'azote et l'oxygène, de sorte à former des germes de précipités d'oxygène et d'azote 9, et à obtenir la structure représentée sur la Figure 2B.

Lors de l'étape de stabilisation (d), certains germes de précipités d'azote et d'oxygène 9 générés lors de l'étape de nucléation (c) vont croître sous forme de grains 8, d'autres (les plus petits) vont se dissoudre. La croissance des grains 8 va permettre de stabiliser lesdits grains 8 de sorte qu'ils auront moins tendance à se redissoudre sous l'effet des traitements ultérieurs, en particulier lors de traitements thermiques. La structure obtenue à l'issue de l'étape de stabilisation (d) est représentée sur la Figure 2C.

L'étape de nucléation (c) et l'étape de stabilisation (d) comprennent chacune un traitement thermique dont les paramètres sont fixés de sorte à obtenir, à l'issue de l'étape (d), de par la présence d'azote interstitiel 6 et d'oxygène interstitiel 7 en concentration intermédiaire entre « low Oi » et « high Oi », des précipités d'oxygène et d'azote 8 dont la taille est comprise entre 10 nm et 50 nm, préférentiellement supérieure à 40 nm. Ainsi, le procédé conforme à l'invention génère des précipités plus petits que ceux obtenus à partir d'un substrat « high Oi ». Comme mentionné précédemment, cette gamme de tailles de précipités représente un bon compromis pour obtenir une meilleure résistance à la propagation des dislocations que dans les substrats « low Oi » tout en observant moins de contraintes mécaniques que dans les substrats « high Oi ».

En outre, les paramètres de l'étape de nucléation (c) et de l'étape de stabilisation (d) sont préférentiellement fixés de sorte à générer une densité de précipité d'azote et d'oxygène 8 comprise entre 10⁷ et 10¹⁰ précipités par cm³, préférentiellement comprise entre 10⁸ et 10⁹ précipités par cm³, soit une densité inférieure de défauts à celle obtenue à partir d'un substrat « high Oi ». L'obtention de précipités dans une telle gamme de concentrations est notamment permise par la présence d'azote interstitiel 6 et par la concentration initiale en oxygène interstitiel 7 du substrat 2. Comme mentionné précédemment, cette gamme de concentrations en précipités représente un bon compromis pour obtenir une bonne résistance à la propagation des dislocations tout en limitant les contraintes.

L'étape de nucléation (c) comprend par exemple un traitement thermique au cours duquel on applique au substrat support 2 une température comprise entre 650 °C et 800 °C, préférentiellement une température comprise entre 700 °C et 750 °C pendant une durée supérieure à une heure, préférentiellement une durée de deux heures.

La température du traitement thermique mis en oeuvre au cours de l'étape de nucléation (c) doit être strictement inférieure à 1000 °C. En effet, une température supérieure ou égale à 1000 °C entrainerait une diffusion trop importante de l'azote interstitiel 6 hors du substrat 2. Une température inférieure à 800 °C permet de limiter encore plus la diffusion de l'azote interstitiel 6 hors du substrat 2.

L'étape de stabilisation (d) comprend par exemple un traitement thermique au cours duquel on applique au substrat support 2 une température supérieure à 900 °C et strictement inférieure à 1000 °C pendant une durée supérieure à deux heures, préférentiellement une durée de quatre heures.

La température du traitement thermique mis en oeuvre au cours de l'étape de stabilisation (d) doit être strictement inférieure à 1000 °C. En effet, une température supérieure ou égale à 1000 °C entrainerait la redissolution des germes de précipités d'oxygène et d'azote 9 générés lors de l'étape de nucléation (c) et la diffusion de l'azote interstitiel 6 hors du substrat 2, de sorte qu'il ne serait pas possible d'obtenir les précipités d'oxygène et d'azote 8.

La température du traitement thermique mis en oeuvre au cours de l'étape de stabilisation (d) est préférentiellement supérieure à 900 °C. L'étape de stabilisation (d) permet ainsi d'obtenir des précipités stables pendant un traitement thermique jusqu'à une température de l'ordre de 1200 °C appliquée pendant plus d'une heure. Les procédés de « back-end » que doit subir ultérieurement la structure présentent généralement un budget thermique inférieur, de sorte que les précipités ne sont pas susceptibles de disparaître lors de ces traitements ultérieurs.

### Etape de formation d'une couche de piégeage de charge (e)

Optionnellement, en référence à la Figure 2D, on forme, lors d'une étape (e), une couche de piégeage de charge 5 sur le substrat support 2, entre le substrat support 2 et la couche électriquement isolante 3. Comme mentionné précédemment, la couche de piégeage de charges est particulièrement avantageuse dans des applications radiofréquences car elle permet de piéger les charges qui s'accumulent sous la couche électriquement isolante 3. La couche de piégeage de charge peut être en silicium polycristallin.

Lors de l'étape de formation de la couche de piégeage de charge (e), le substrat support 2 ne doit pas être porté à une température supérieure à 1200 °C pendant plus d'une heure ou deux heures. En effet, au-delà de 1200 °C, les précipités d'oxygène et d'azote 8 peuvent se redissoudre et l'azote interstitiel 6 diffuser hors du matériau du substrat support 2.

L'étape de formation de la couche de piégeage de charges comprend par exemple un dépôt chimique en phase vapeur (CVD) ou un dépôt par épitaxie sur le substrat support à une température pouvant être comprise entre 600 °C et 1100°C selon la technique utilisée, en présence ou en l'absence d'un germe.

Eventuellement, la couche de piégeage de charges peut être formée avant le traitement thermique de nucléation.

En effet, les étapes de nucléation (c) et de stabilisation (d) susmentionnées sont réalisées avec des budgets thermiques suffisamment faibles pour éviter ou tout au moins limiter la recristallisation du silicium polycristallin de la couche de piégeage de charge 5.

De préférence, la couche de piégeage de charges 5 est formée après le traitement thermique de nucléation (c), voire après le traitement thermique de stabilisation (d), afin d'éviter de modifier la structure de cette couche lors de ces traitements.

### Etape d'assemblage d'un substrat donneur sur le substrat support (a) et étape de transfert d'une couche semi-conductrice (b)

On réalise une étape (a) d'assemblage d'un substrat donneur d'une couche semi-conductrice à transférer 4 sur le substrat support 2, une couche électriquement isolante 3 étant à l'interface entre le substrat support 2 et la couche semi-conductrice à transférer 4. On réalise ensuite une étape (b) de transfert de la couche semi-conductrice à transférer 4 de sorte à obtenir la structure multicouche 1 représentée sur la Figure 1.

Le substrat donneur de la première couche semi-conductrice 4 se présente sous la forme d'une plaque, par exemple une plaque circulaire de même dimension que le substrat support 2. Le substrat donneur comprend un matériau semi-conducteur, par exemple du silicium monocristallin.

Le transfert de couche peut par exemple être réalisé selon un procédé Smart Cut^{™}. Dans ce cas, l'étape (a) comprend les sous-étapes suivantes :
- fourniture d'un substrat donneur de la couche semi-conductrice monocristalline 4 représenté sur la figure 2E,
- formation d'une zone de fragilisation dans ledit premier substrat donneur de sorte à délimiter la première couche semi-conductrice 4 à transférer (traits pointillés de la Figure 2E),
- collage du substrat donneur sur le substrat support 2, la couche électriquement isolante 3 étant à l'interface entre le substrat support 2 et le substrat donneur, de sorte à obtenir la structure représentée sur la figure 2F.
L'étape (b) comprend le détachement du substrat donneur au niveau de la zone de fragilisation de sorte à transférer la couche semi-conductrice 4 et à former la structure multicouche 1 représentée sur la figure 1.

La zone de fragilisation peut être créée par co-implantation d'atomes d'hélium et d'atomes d'hydrogène dans le substrat donneur de la couche semi-conductrice. Alternativement, la zone de fragilisation est créée par implantation d'atomes d'hydrogène ou d'hélium seuls.

Le détachement le long de la zone de fragilisation peut être déclenché par une action mécanique, un apport d'énergie thermique, éventuellement en combinaison, ou tout autre moyen adapté.

De manière alternative au procédé Smart Cut ^{™}, l'étape (a) peut comprendre le collage du substrat donneur de la couche semi-conductrice à transférer 4 sur le substrat support 2, la couche électriquement isolante 3 étant à l'interface, tandis que l'étape (b) peut comprendre l'amincissement dudit substrat donneur par sa face opposée à la face collée sur le substrat support 2 jusqu'à l'obtention de l'épaisseur souhaitée pour la couche semi-conductrice 4.

La couche électriquement isolante 3 est par exemple une couche d'oxyde telle qu'une couche d'oxyde de silicium. La couche d'oxyde électriquement isolante 3 peut être formée sur le substrat support 2 éventuellement recouvert de la couche de piégeage de charges 5 ou sur le substrat donneur de la couche semi-conductrice 4 préalablement au collage dudit substrat donneur sur ledit substrat support.

Durant toute l'étape d'assemblage du substrat donneur sur le substrat support (a) et l'étape de la couche semi-conductrice 4 (b), le substrat support 2 ne doit pas être porté à une température supérieure à 1200 °C pendant plus d'une heure pour ne pas engendrer la redissolution des précipités d'oxygène et d'azote 8.

Si la structure multicouche comprend une couche de piégeage de charges 5 en un matériau polycristallin, la température appliquée ne doit pas excéder 1100 °C pendant plus de deux heures pour ne pas provoquer la recristallisation de ladite couche.

Selon des modes de réalisation alternatifs du procédé selon l'invention, les étapes de nucléation (c) et de stabilisation (d) peuvent être mises en oeuvre après l'étape (a) d'agencement du substrat donneur sur le substrat support 2 éventuellement recouvert de la couche de piégeage de charges 5 ou après l'étape (b) de transfert de la couche semi-conductrice 4. Selon chacun de ces modes de réalisation, chaque étape (a), (b), (c) (d) et (e) est par ailleurs réalisée tel que décrit précédemment.

Toutefois, les étapes précédant l'étape de nucléation (c) et l'étape de stabilisation (d) ne doivent pas comprendre l'application d'une température supérieure ou égale à 1000 °C sur une durée de l'ordre d'une heure à quelques heures. En effet, une température supérieure ou égale à 1000 °C entrainerait la diffusion de l'azote interstitiel 6 hors du substrat support, de sorte qu'on ne pourrait pas former les précipités d'oxygène et d'azote 8.

Selon encore d'autres modes de réalisation du procédé selon l'invention, l'étape de nucléation (c) et l'étape de stabilisation (d) ne sont pas consécutives, de sorte qu'au moins une étape parmi les étapes (a), (b) et (e) peut être mise entre l'étape de nucléation (c) et l'étape de stabilisation (d). Selon chacun de ces modes de réalisation, chaque étape (a), (b), (c) (d) et (e) est par ailleurs réalisée tel que décrit précédemment.

Lorsque les étapes (c) et (d) ne sont pas consécutives, les étapes précédant l'étape de stabilisation (d) ne doivent pas comprendre l'application d'une température supérieure ou égale à 1000 °C sur une durée de l'ordre d'une heure à quelques heures pour ne pas provoquer la diffusion de l'azote interstitiel 6 hors du substrat support 2 et la redissolution des germes de précipités d'oxygène et d'azote 9 générés lors de l'étape de nucléation (c).

Finalement, quel que soit le mode de réalisation choisi, les étapes postérieures à l'étape de stabilisation (d) ne doivent pas comprendre l'application d'une température supérieure à 1200 °C pendant plus d'une heure pour ne pas engendrer la redissolution des précipités d'oxygène et d'azote 8.

## Revendications

1. Procédé de fabrication d'une structure multicouche de type semi-conducteur sur isolant (1) comprenant les étapes suivantes :
(a) assemblage d'un substrat support (2) réalisé en un matériau semi-conducteur présentant une résistivité électrique supérieure ou égale à 500 Ω.cm et contenant de l'azote interstitiel (6) et de l'oxygène interstitiel (7), la concentration initiale en oxygène interstitiel (6) dans le substrat support (2) étant comprise entre 15 old ppma et 25 old ppma (mesurée selon la norme ASTM79), et d'un substrat donneur d'une couche semi-conductrice à transférer (4), une couche électriquement isolante (3) étant à l'interface entre le substrat support (2) et le substrat donneur,
(b) transfert de ladite couche semi-conductrice (4) sur le substrat support,
**caractérisé en ce que**:
le procédé comprenant en outre une étape (c) de nucléation comprenant un traitement thermique pour précipiter de façon contrôlée au moins une partie de l'oxygène interstitiel (7) et au moins une partie de l'azote interstitiel (6) de sorte à former des germes (9) de précipités d'oxygène et d'azote (8) et une étape (d) de stabilisation comprenant un traitement thermique pour faire croître lesdits germes de précipités d'oxygène et d'azote jusqu'à une taille comprise entre 10 nm et 50 nm,
dans lequel, à l'issue de l'étape (d) de stabilisation, le substrat support (2) comprend une concentration en précipités d'oxygène et d'azote (8) comprise entre 10⁷ cm⁻³ et 10¹⁰ cm⁻³.

2. Procédé selon la revendication 1, comprenant en outre, avant l'étape d'assemblage (a), la formation d'une couche de piégeage de charges (5) sur le substrat support (2), ladite couche de piégeage de charges (5) étant agencée entre le substrat support (2) et la couche électriquement isolante (3).

3. Procédé selon la revendication 2, dans lequel la formation de ladite couche de piégeage de charges (3) comprend le dépôt d'une couche de silicium polycristallin sur le substrat support.

4. Procédé selon la revendication 3, dans lequel le dépôt de ladite couche de silicium polycristallin est réalisé après l'étape (d) de stabilisation des précipités d'oxygène et d'azote (8).

5. Procédé selon l'une quelconque des revendications 1 à 4, **caractérisé en ce que** la concentration initiale en azote interstitiel (6) dans le substrat support (2) est comprise entre 10¹⁴ atomes/cm³ et 10¹⁵ atomes/cm³.

6. Procédé selon l'une quelconque des revendications 1 à 5, dans lequel, à l'issue de l'étape (d) de stabilisation, le substrat support (2) comprend une concentration en précipités d'oxygène et d'azote (8) comprise entre 10⁸ cm⁻³ et 10⁹ cm⁻³.

7. Procédé selon l'une des revendications 1 à 6, **caractérisé en ce que** l'étape de nucléation (c) et l'étape de stabilisation (d) comprennent chacune un traitement thermique, la température appliquée durant le traitement thermique de nucléation (c) étant inférieure à la température appliquée lors du traitement thermique de stabilisation (d) et la durée du traitement thermique de nucléation (c) étant inférieure à la durée du traitement thermique de stabilisation (d).

8. Procédé selon l'une quelconque des revendications 1 à 7, dans lequel l'étape de nucléation (c) comprend l'application d'une température comprise entre 650 °C et 800 °C, préférentiellement une température comprise entre 700 °C et 750 °C, pendant une durée supérieure à une heure, préférentiellement une durée de deux heures.

9. Procédé selon l'une quelconque des revendications 1 à 8, dans lequel l'étape de stabilisation (d) comprend l'application d'une température supérieure à 900 °C, préférentiellement une température de 950 °C, pendant une durée supérieure à deux heures, préférentiellement une durée de quatre heures.

10. Procédé selon l'une quelconque des revendications 1 à 9, dans lequel les étapes de nucléation (c) et de stabilisation (d) sont exécutées directement l'une à la suite de l'autre avant l'étape (a) d'assemblage.

11. Structure multicouche de type semi-conducteur sur isolant comportant, de sa face arrière vers sa face avant, un substrat support (2), une couche électriquement isolante (3) et une couche semi-conductrice (4), **caractérisé en ce que** le substrat support (2) est réalisé en un matériau semi-conducteur présentant une résistivité électrique supérieure ou égale à 500 Ω.cm et comportant des précipités d'oxygène et d'azote (8) présentant une taille comprise entre 10 nm et 50 nm, dans une concentration comprise entre 10⁷ cm⁻³ et 10¹⁰ cm⁻³.

12. Structure selon la revendication 11 comprenant en outre une couche de piégeage de charge (5) entre le substrat support (2) et la couche électriquement isolante (3).

13. Structure selon l'une quelconque des revendications 11 ou 12 **caractérisée en ce que** la concentration résiduelle en oxygène interstitiel (7) dans le substrat support (2) est inférieure à 15 old ppma, préférentiellement inférieure à 12 old ppma (mesurée selon la norme ASTM79).

## Patentansprüche

1. Verfahren zur Herstellung einer mehrschichtigen Halbleiter-auf-Isolator-Struktur (1), das die folgenden Schritte umfasst:
(a) Zusammenbau eines Trägersubstrats (2), das aus einem Halbleitermaterial besteht, das einen spezifischen elektrischen Widerstand von größer oder gleich 500 Ω.cm aufweist und interstitiellen Stickstoff (6) und interstitiellen Sauerstoff (7) enthält, wobei die Anfangskonzentration an interstitiellem Sauerstoff (6) in dem Trägersubstrat (2) zwischen 15 old ppma und 25 old ppma (gemessen gemäß der Norm ASTM79) beträgt, und eines Donorsubstrats einer zu übertragenden Halbleiterschicht (4), wobei eine elektrisch isolierende Schicht (3) sich an der Grenzfläche zwischen dem Trägersubstrat (2) und dem Donorsubstrat befindet,
(b) Übertragen der Halbleiterschicht (4) auf das Trägersubstrat, **dadurch gekennzeichnet, dass**: Das Verfahren ferner einen Schritt (c) der Keimbildung, die eine Wärmebehandlung zum kontrollierten Ausfällen mindestens eines Teils des interstitiellen Sauerstoffs (7) und mindestens eines Teils des interstitiellen Stickstoffs (6) umfasst, derart dass Keime (9) von Sauerstoff- und Stickstoffausfällungen (8) gebildet werden, und einen Schritt (d) der Stabilisierung umfasst, der eine Wärmebehandlung umfasst, um die Keime von Sauerstoff- und Stickstoffausfällungen bis zu einer Größe zwischen 10 nm und 50 nm wachsen zu lassen,
wobei am Ende des Schritts (d) der Stabilisierung das Trägersubstrat (2) eine Konzentration an Sauerstoff- und Stickstoffausfällungen (8) zwischen 10⁷ cm⁻³ und 10¹⁰ cm⁻³ umfasst.

2. Verfahren nach Anspruch 1, das ferner vor dem Schritt des Zusammenbaus (a) die Bildung einer Ladungseinfangschicht (5) auf dem Trägersubstrat (2) umfasst, wobei die Ladungseinfangschicht (5) zwischen dem Trägersubstrat (2) und der elektrisch isolierenden Schicht (3) angeordnet ist.

3. Verfahren nach Anspruch 2, wobei die Bildung der Ladungseinfangschicht (3) das Abscheiden einer polykristallinen Siliziumschicht auf dem Trägersubstrat umfasst.

4. Verfahren nach Anspruch 3, wobei die Abscheidung der polykristallinen Siliziumschicht nach dem Schritt (d) der Stabilisierung der Sauerstoff- und Stickstoffausfällungen (8) ausgeführt wird.

5. Verfahren nach einem der Ansprüche 1 bis 4, **dadurch gekennzeichnet, dass** die Anfangskonzentration an interstitiellem Stickstoff (6) in dem Trägersubstrat (2) zwischen 10¹⁴ Atome/cm³ et 10¹⁵ Atome/cm³ beträgt.

6. Verfahren nach einem der Ansprüche 1 bis 5, wobei am Ende des Schritts (d) der Stabilisierung das Trägersubstrat (2) eine Konzentration an Sauerstoff- und Stickstoffausfällungen (8) zwischen 10⁸ cm⁻³ und 10⁹ cm⁻³ umfasst.

7. Verfahren nach einem der Ansprüche 1 bis 6, **dadurch gekennzeichnet, dass** der Schritt der Keimbildung (c) und der Schritt der Stabilisierung (d) jeweils eine Wärmebehandlung umfassen, wobei die während der Wärmebehandlung zur Keimbildung (c) angewandte Temperatur niedriger als die bei der Wärmebehandlung zur Stabilisierung (d) angewandte Temperatur ist und die Dauer der Wärmebehandlung zur Keimbildung (c) kürzer als die Dauer der Wärmebehandlung zur Stabilisierung (d) ist.

8. Verfahren nach einem der Ansprüche 1 bis 7, wobei der Schritt der Keimbildung (c) die Anwendung einer Temperatur zwischen 650°C und 800°C, vorzugsweise einer Temperatur zwischen 700°C und 750°C, während einer Dauer von länger als einer Stunde, vorzugsweise einer Dauer von zwei Stunden, umfasst.

9. Verfahren nach einem der Ansprüche 1 bis 8, wobei der Schritt der Stabilisierung (d) die Anwendung einer Temperatur von höher als 900°C, vorzugsweise einer Temperatur von 950°C, während einer Dauer von länger als zwei Stunden, vorzugsweise einer Dauer von vier Stunden, umfasst.

10. Verfahren nach einem der Ansprüche 1 bis 9, wobei die Schritte der Keimbildung (c) und der Stabilisierung (d) direkt aufeinanderfolgend vor dem Schritt (a) des Zusammenbaus ausgeführt werden.

11. Mehrschichtige Halbleiter-auf-Isolator-Struktur, die von ihrer Rückseite zu ihrer Vorderseite ein Trägersubstrat (2), eine elektrisch isolierende Schicht (3) und eine Halbleiterschicht (4) umfasst, **dadurch gekennzeichnet, dass** das Trägersubstrat (2) aus einem Halbleitermaterial besteht, das einen spezifischen elektrischen Widerstand von größer oder gleich 500 Ω.cm aufweist, und Sauerstoff- und Stickstoffausfällungen (8), die eine Größe zwischen 10 nm und 50 nm aufweisen, in einer Konzentration zwischen 10⁷ cm⁻³ und 10¹⁰ cm⁻³ umfasst.

12. Struktur nach Anspruch 11, die ferner eine Ladungseinfangschicht (5) zwischen dem Trägersubstrat (2) und der elektrisch isolierenden Schicht (3) umfasst.

13. Struktur nach einem der Ansprüche 11 oder 12, **dadurch gekennzeichnet, dass** die Restkonzentration an interstitiellem Sauerstoff (7) in dem Trägersubstrat (2) kleiner als 15 old ppma, vorzugsweise kleiner als 12 old ppma (gemessen gemäß der Norm ASTM79), ist.

## Claims

1. A method of manufacturing a semiconductor-on-insulator (SOI) multilayer structure (1) comprising the following steps:
(a) assembling a support substrate (2) made of a semiconductor material having an electrical resistivity of 500 Ω·cm or greater and containing interstitial nitrogen (6) and interstitial oxygen (7), the initial concentration of interstitial oxygen (6) in the carrier substrate (2) being between 15 old ppma and 25 old ppma (measured in accordance with ASTM79), and a donor substrate comprising a semiconductor layer to be transferred (4), an electrically insulating layer (3) being located at the interface between the support substrate (2) and the donor substrate,
(b) transfer of said semiconductor layer (4) onto the carrier substrate, **characterised in that**: the process further comprises a step (c) of nucleation comprising a heat treatment to precipitate, in a controlled manner, at least part of the interstitial oxygen (7) and at least part of the interstitial nitrogen (6) so as to form nuclei (9) of oxygen and nitrogen precipitates (8), and a stabilisation step (d) comprising a heat treatment to grow said nuclei of oxygen and nitrogen precipitates to a size of between 10 nm and 50 nm,
wherein, at the end of the stabilisation step (d), the support substrate (2) comprises a concentration of oxygen and nitrogen precipitates (8) of between 10⁷cm⁻³ and 10¹⁰cm⁻³.

2. A method according to claim 1, further comprising, prior to the assembly step (a), the formation of a charge trapping layer (5) on the support substrate (2), said charge trapping layer (5) being arranged between the support substrate (2) and the electrically insulating layer (3).

3. A method according to claim 2, wherein the formation of said charge trapping layer (3) comprises depositing a layer of polycrystalline silicon onto the support substrate.

4. A method according to claim 3, wherein the deposition of said polycrystalline silicon layer is carried out after step (d) of stabilising the oxygen and nitrogen precipitates (8).

5. A method according to any one of claims 1 to 4, **characterised in that** the initial concentration of interstitial nitrogen (6) in the support substrate (2) is between 10¹⁴ atoms/cm³ and 10¹⁵ atoms/cm³.

6. A method according to any one of claims 1 to 5, in which, at the end of the stabilisation step (d), the support substrate (2) comprises a concentration of oxygen and nitrogen precipitates (8) of between 10⁸ cm⁻³ and 10⁹ cm⁻³.

7. A method according to any one of claims 1 to 6, **characterised in that** the nucleation step (c) and the stabilisation step (d) each comprise a heat treatment, the temperature applied during the nucleation heat treatment (c) being lower than the temperature applied during the stabilisation heat treatment (d), and the duration of the nucleation heat treatment (c) being shorter than the duration of the stabilisation heat treatment (d).

8. A method according to any one of claims 1 to 7, wherein the nucleation step (c) comprises applying a temperature of between 650 °C and 800 °C, preferably a temperature of between 700 °C and 750 °C, for a duration of more than one hour, preferably a duration of two hours.

9. A method according to any one of claims 1 to 8, wherein the stabilisation step (d) comprises applying a temperature of more than 900 °C, preferably a temperature of 950 °C, for a duration of more than two hours, preferably a duration of four hours.

10. A method according to any one of claims 1 to 9, wherein the nucleation (c) and stabilisation (d) steps are carried out directly one after the other prior to the assembly (a) step.

11. A semiconductor-on-insulator multilayer structure comprising, from its rear face towards its front face, a support substrate (2), an electrically insulating layer (3) and a semiconductor layer (4), **characterised in that** the support substrate (2) is made of a semiconductor material having an electrical resistivity of 500 Ω·cm or greater and comprising oxygen and nitrogen precipitates (8) with a size of between 10 nm and 50 nm, in a concentration of between 10⁷ cm⁻³ and 10¹⁰ cm⁻³.

12. A structure according to claim 11, further comprising a charge trapping layer (5) between the support substrate (2) and the electrically insulating layer (3).

13. A structure according to any one of claims 11 or 12, **characterised in that** the residual concentration of interstitial oxygen (7) in the support substrate (2) is less than 15 old ppma, preferably less than 12 old ppma (measured in accordance with ASTM79).
